# EUROPÄISCHE PATENTANMELDUNG

(11) **EP 3 280 039 A1**
(43) Veröffentlichungstag der Anmeldung: **07.02.2018**
(21) Anmeldenummer: 16182202.8
(22) Anmeldetag: 01.08.2016
(51) Int. Cl.: H02M 1/08

(54) **VERFAHREN ZUR ANSTEUERUNG PARALLEL ANGEORDNETER, RÜCKWÄRTS LEITFÄHIGER HALBLEITERSCHALTER**

(71) Anmelder: Siemens Aktiengesellschaft, 80333 München (DE)
(72) Erfinder: Fleisch, Karl, 91054 Erlangen (DE)

(57) **Zusammenfassung**

Die Erfindung betrifft ein Verfahren zur Ansteuerung mindestens zweier rückwärts leitfähiger Halbleiterschalter (1), wobei die mindestens zwei rückwärts leitfähigen Halbleiterschalter (1) in einer Parallelschaltung (2) angeordnet sind. Zur Verbesserung des Schaltverhaltens wird vorgeschlagen, zumindest zwei der in einer Parallelschaltung angeordneten rückwärts leitfähigen Halbleiterschalter (1) zumindest zeitweise mit einer unterschiedlichen Spannung anzusteuern. Die Erfindung betrifft weiter Schaltelement (3) mit zwei in einer Parallelschaltung (2) angeordneten rückwärts leitfähigen Halbleiterschalter (1) und einer Ansteuereinheit (4) oder zumindest einem Teil (5) einer Ansteuereinheit (4) zur Ansteuerung der rückwärts leitfähigen Halbleiterschalter (1), wobei ein Stromsensor (6) zur Erfassung eines durch die Parallelschaltung (2) fließenden Laststroms (i_{L}) mit einer Regelungsbaugruppe (7) zur Auswertung von Messwerten des Stromsensors (6) verbindbar ist, wobei mittels der Ansteuereinheit (4) oder mittels des Teils (5) der Ansteuereinheit (4) die einzelnen rückwärts leitfähigen Halbleiterschalter (1) jeweils mit unterschiedlichen Spannungen ansteuerbar sind.

## Beschreibung

Die Erfindung betrifft ein Verfahren zur Ansteuerung mindestens zweier rückwärts leitfähiger Halbleiterschalter, wobei die mindestens zwei rückwärts leitfähigen Halbleiterschalter in einer Parallelschaltung angeordnet sind. Die Erfindung betrifft weiter ein Schaltelement mit mindestens zwei in einer Parallelschaltung angeordneten rückwärts leitfähigen Halbleiterschaltern. Ferner betrifft die Erfindung einen Stromrichter mit einer Reihenschaltung aus mindestens zwei solchen Schaltelementen.

Bei rückwärts leitfähigen Halbleiterschaltern sind die Funktion des schaltenden Elementes und die Diodenfunktion in einem Chip vereint. Insbesondere sind IGBTs (Insulated-Gate-Bipolar-Transistoren) als rückwärts leitfähige IGBTs bekannt. Diese werden auch als RC-IGBT bezeichnet. Im Gegensatz zu herkömmlichen IGBTs kann mit Hilfe der Ansteuerung am Gate-Kontakt nicht nur das Verhalten des Schaltelements, in diesem Fall die IGBT Funktion, sondern auch das Verhalten im Diodenmodus beeinflusst werden.

Ein Verfahren zur Steuerung zweier elektrisch in Reihe geschalteter rückwärts leitfähiger IGBTs ist in der DE 10 2011 003 938 A1 offenbart. Dieses Dokument beschreibt ein Steuerverfahren zweier elektrisch in Reihe geschalteter IGBTs einer Halbbrücke, an der eine Betriebsgleichspannung ansteht, wobei diese rückwärts leitfähigen IGBTs über drei Schaltzustände verfügen.

Um die Leistungsfähigkeit, beispielsweise eines Stromrichters zu erhöhen, können mehrere Halbleiterschalter in einer Parallelschaltung angeordnet werden. Diese Parallelschaltung erlaubt es, den zu schaltenden Strom zu erhöhen, da sich der Strom auf die unterschiedlichen Zweige der Parallelschaltung aufteilt. Damit kann die Leistungsfähigkeit eines Schaltelements, beispielsweise in einem Stromrichter, gesteigert werden, da sich ein entsprechend hoher schaltbarer Gesamtstrom ergibt. Dabei dienen die Halbleiterschalter dazu, den Lastanschluss, der auch als Phasenanschluss bezeichnet wird, des Stromrichters mit einem der Zwischenkreisspannungspotentiale zu verbinden. Da die parallel angeordneten Halbleiterschalter den gleichen Phasenanschluss schalten, hat es sich bewährt, die Halbleiterschalter, die parallel angeordnet sind, jeweils mit dem gleichen Ansteuersignal anzusteuern. Dies geschieht sowohl bei herkömmlichen IGBTs als auch bei rückwärts leitfähigen IGBTs.

Ein rückwärts leitfähiger IGBT kann je nach Stromflussrichtung entweder den IGBT-Modus oder den Diodenmodus annehmen. Fließt ein Strom vom Kollektor zum Emitter, so befindet sich der rückwärts leitfähige IGBT im IGBT-Modus. Fließt hingegen der Strom vom Emitter zum Kollektor, so befindet sich der rückwärts leitfähige IGBT im Diodenmodus. Wenn sich die Richtung des Laststroms umdreht, wechselt der rückwärts leitfähige IGBT vom Dioden-Modus in den IGBT-Modus bzw. vom IGBT-Modus in den Dioden-Modus. Somit bewirkt eine Änderung der Stromrichtung durch den IGBT eine Änderung des entsprechenden Modi. Für den Betrieb im IGBT-Modus wird eine positive Gate-Emitter-Spannung benötigt (offener Kanal für den Stromfluss) während für den Diodenmodus eine negative Gate-Emitter-Spannung benötigt wird (geschlossener Kanal, um ein Abfließen der Elektronen zu verhindern). Daher muss der Nulldurchgang des Laststroms und damit auch der Nulldurchgang des entsprechenden Stroms durch den Halbleiterschalter mit hoher Genauigkeit bestimmt werden, da dieser Zeitpunkt des Wechsels zwischen den beschriebenen Modi darstellt. Eine zu frühe oder zu späte Spannungsänderung am Gate-Anschluss kann Schäden am RC-IGBT verursachen oder den durch die übergeordnete Steuerung vorgegebenen Schaltzustand verfälschen bei dem eine falsche Spannungszeitfläche am Ausgang des Umrichters erzeugt wird.

Die Dioden neigen bei kleinen Lastströmen dazu, abzureißen. Das Abreißen wird auch als snappiges-Verhalten (fehlendes soft-recovery) bezeichnet. Durch ein sehr hohes di/dt des Diodenstroms am Ende der Stromflussdauer neigen die Dioden zudem dazu, eine hohe Spannung zu induzieren, welche das Bauelement selbst gefährdet und EMV-Probleme auslösen kann.

Bei IGBTs, die nicht rückwärts leitfähig sind, sondern parallel zum IGBT eine Dioden aufweisen, hat diese Diode keinen Steueranschluss. Damit fehlt dem nicht rückwärts leitfähigen IGBT die Möglichkeit, die gespeicherte Ladung der Diode zu steuern. Somit ist es nicht möglich, dass Verhalten dieser Dioden zu beeinflussen.

Wenn ein Laststrom, der durch einen Halbleiterschalter fließt, von diesem Halbleiterschalter auf einen anderen Halbleiterschalter übertragen wird, so wird dies als Kommutierung bezeichnet. Der Abbau des Laststroms durch den einen Halbleiterschalter wird auch als Abkommutierung bezeichnet. Sobald der Strom durch den Halbleiterschalter erloschen ist, ist dieser abkommutiert.

Der Erfindung liegt die Aufgabe zugrunde, das Schaltverhalten von parallel angeordneten Halbleiterschaltern zu verbessern.

Die Aufgabe wird durch ein Verfahren zur Ansteuerung mindestens zweier rückwärts leitfähiger Halbleiterschalter gelöst, wobei die mindestens zwei rückwärts leitfähigen Halbleiterschalter in einer Parallelschaltung angeordnet sind, wobei zumindest zwei der rückwärts leitfähigen Halbleiterschalter zumindest zeitweise mit einer unterschiedlichen Spannung angesteuert werden. Weiter wird die Aufgabe durch ein Schaltelement mit mindestens zwei in einer Parallelschaltung angeordneten rückwärts leitfähigen Halbleiterschaltern und einer Ansteuereinheit oder zumindest einem Teil einer Ansteuereinheit zur Ansteuerung der rückwärts leitfähigen Halbleiterschalter gelöst, wobei ein Stromsensor zur Erfassung eines durch die Parallelschaltung fließenden Laststroms mit einer Regelungsbaugruppe zur Auswertung von Messwerten des Stromsensors verbindbar ist, wobei mittels der Ansteuereinheit oder mittels des Teils der Ansteuereinheit die einzelnen rückwärts leitfähigen Halbleiterschalter jeweils mit unterschiedlichen Spannungen ansteuerbar sind. Ferner wird die Aufgabe durch einen Stromrichter mit mindestens einer Reihenschaltung aus mindestens zwei solchen Schaltelementen, einer Regelungsbaugruppe zur Auswertung von Messwerten des Stromsensors und einem Phasenanschluss zum Anschluss einer Last gelöst, wobei ein Verbindungspunkt der zwei Schaltelemente mit dem Phasenanschluss elektrisch verbunden ist, wobei der Stromsensor zwischen dem Phasenschluss und dem Verbindungspunkt angeordnet ist, wobei zur Übertragung von Messsignalen der Stromsensor mit der Regelungsbaugruppe verbunden ist.

Vorteilhafte Ausgestaltungen der Erfindung sind in den abhängigen Ansprüchen angegeben.

Der Erfindung liegt die Erkenntnis zugrunde, dass sich die Parallelschaltung von RC-IGBTs dadurch verbessern lässt, dass die einzelnen parallelen Halbleiterschalter zumindest zeitweise mit unterschiedlicher Gate-Spannung, d.h. unterschiedlicher Gate-Emitter Spannung, angesteuert werden, um die Aufteilung des Stromes durch die einzelnen Halbleiterschalter, insbesondere durch die im Dioden-Modus befindlichen Halbleiterschalter, zu beeinflussen. Die erfindungsgemäße Lösung beruht zum einen darauf, bei parallelgeschalteten RC-IGBTs die Gate-Emitter-Strecken der parallelen RC-IGBTs mit verschiedenen Gate-Spannungen anzusteuern. Damit stellen sich in den einzelnen RC-IGBT, beispielsweise im Dioden-Modus, verschiedene Kollektor-Emitter-Ströme ein und damit auch verschiedene gespeicherte Ladungen. Damit können die Verluste, beispielsweise die Schaltverluste, im Betrieb deutlich reduziert werden.

Besonders vorteilhaft ist es, parallele RC-IGBTs, beispielsweise im Dioden-Modus, so anzusteuern, dass zumindest zum Stromnulldurchgang ein Teil der RC-IGBTs mit negativer Gate-Spannung angesteuert wird und der verbleibende Teil der parallelen Halbleiterschalter mit einer positiven Gate-Spannung angesteuert wird. Damit kann die Stromrichtungserkennung erheblich einfacher ausgeführt werden, weil die Anforderung an die Genauigkeit der Erkennung des Stromnulldurchgangs erheblich sinkt. Damit ist es möglich, die Stromrichtungserkennung zu vereinfachen bzw. die Stromrichtungserkennung einzusparen und von einer für regelungstechnische Zwecke bereits vorhandenen Strommessung erledigen zu lassen. Es hat sich gezeigt, dass die Genauigkeit der Laststrommessung, die sowieso bereits für regelungstechnische Zwecke vorhanden ist, für die Erkennung des Stromnulldurchgangs ausreichend ist. Auf eine zusätzliche genaue Strommessung mit einer sehr genauen Stromrichtungserkennung direkt an den einzelnen Parallelschaltungen der Halbleiterschalter, beispielsweise innerhalb des Stromrichters, kann verzichtet werden. Da die Stromwandler mit hoher Genauigkeit sehr teuer sind, entsteht hiermit ein deutlicher wirtschaftlicher Vorteil.

Das vorgeschlagene Verfahren beruht auf der Erkenntnis, dass sich in der zeitlichen Umgebung bei der Änderung der Richtung des Laststroms der Betrag des Laststroms derart gering ist, dass nicht alle RC-IBGTs der Parallelschaltung zum Führen dieses Laststroms erforderlich sind. Somit wird bei einem aus mindestens zwei RC-IGBTs aufgebauten Schalter im Diodenmodus nur ein erster Teil der Halbleiterschalter, die so bezeichneten ersten Halbleiterschalter oder zumindest ein erster Halbleiterschalter, mit einer negativen Gate-Spannung angesteuert und der (verbleibende) zweite Teil der parallelen Halbleiterschalter, die so bezeichneten zweiten Halbleiterschalter oder zumindest ein zweiter Halbleiterschalter, mit einer positiven Gate-Spannung. Somit fließt vor dem Nulldurchgang der Strom bevorzugt, d.h. in erster Linie, durch den oder die ersten Halbleiterschalter und nach dem Nulldurchgang der Strom durch den oder die zweiten Halbleiterschalter, ohne dass eine Änderung der Ansteuerung am Gate der Halbleiterschalter vorgenommen werden muss. Somit muss dieser Augenblick des Nulldurchgangs auch nicht mehr genau bestimmt werden. Dies ist unter anderem deshalb möglich, da in der Nähe des Nulldurchgangs des Laststroms der Betrag des Laststroms so gering ist, dass nicht alle Halbleiterschalter der Parallelschaltung zum Führen des Laststroms erforderlich sind.

Durch getrennte Ansteuerkanäle können parallele RC-IGBTs im Dioden-Modus mit verschiedenen Gate-Emitter-Spannungen angesteuert werden. Die Ansteuerung wird so gewählt, dass abhängig von der gewünschten gespeicherten Ladungsträgermenge (also im Allgemeinen abhängig vom zu führenden Laststrom) so vielen RC-IGBT im Dioden-Modus eine negative Ansteuerspannung zugeführt wird (oder anders ausgedrückt, der MOS-Kanal geschlossen wird) wie nötig sind. Den restlichen parallelen RC-IGBTs im Dioden-Modus wird eine positive Gate-Emitter-Spannung zugeführt, was dazu führt, dass sie sich nur in sehr, sehr geringem Masse an der Stromführung beteiligen. Damit werden sowohl die Einschaltverluste des kommutierenden RC-IGBT im IGBT Modus in der gleichen Phase als auch die Abschaltverluste des RC-IGBT im Dioden-Modus verringert. Zudem wird der Laststrom vorteilafterweise auf maximal so viele RC-IGBTs im Dioden-Modus verteilt wie gerade notwendig sind, was ein "Abreißen" des Stromes mit hohen induzierten Spannungen verhindert.

Die Ansteuerung mit unterschiedlichen Vorzeichen in der Ansteuerspannung, die an das Gate angelegt wird, ist möglich, wenn in der Umgebung des Nulldurchgangs der Betrag des Stromes derart klein ist, dass für das Führen des Stroms nicht alle parallel angeordneten RC-IBGTs für das Tragen des Stromes aufgrund der maximalen Strombelastbarkeit erforderlich sind. Mit anderen Worten definiert sich die Umgebung des Nulldurchgangs unter anderem dadurch, dass nur ein Teil der parallel angeordneten Halbleiterschalter in dieser zeitlichen Umgebung für das Tragen des Stroms erforderlich sind. Insbesondere bei sinusförmigem Verlauf des Stroms oder nahezu sinusförmigen Verlauf des Stroms hat sich das Verfahren als besonders vorteilhaft erwiesen, da es eine Umgebung in der Nähe der Nullstelle gibt, an der die Werte des Stroms derart klein sind, dass nicht alle parallelen Halbleiterschalter zum Tragen des Stroms benötigt werden und gleichzeitig die Steigung im Bereich der Nullstelle derart groß ist, dass man diese Nullstelle sehr genau bestimmen muss, wenn man alle parallelen Halbleiterschalter gleich ansteuern wollte, um einen Schaden am Halbleiterschalter durch den schnell ansteigenden Strom und einer unpassenden Ansteuerung zu verhindern.

Insbesondere für den Fall, dass die Parallelschaltung zwei Halbleiterschalter umfasst, kann bei einem Strom, der kleiner ist als die Hälfte des Maximalwertes, insbesondere der Amplitude bei einem Sinusverlauf, jeweils ein Halbleiterschalter mit einer positiven und der zweite Halbleiter mit einer negativen Gate-Spannung angesteuert werden.

Diese Überlegung kann ohne weiteres auf den IGBT-Modus übertragen werden. Auch hier kann vor einem Nulldurchgang, d.h. einem Wechsel der RC-IGBTs vom IGBT-Modus in den Dioden-Modus ein erster Teil der parallel angeordneten Halbleiter mit negativer Gate-Spannung angesteuert werden und der zweite (verbleibende) Teil mit einer positiven Gate-Spannung. Auch diese Ansteuerung bewirkt, dass die genaue Erkennung des Stromnulldurchgangs nicht mehr erforderlich ist. Vor dem Nulldurchgang fließt der Laststrom durch die zweiten Halbleiterschalter und nach dem Nulldurchgang durch die ersten Halbleiterschalter, ohne dass zum Nulldurchgang Schalthandlungen, d.h. Änderungen in den Gate Spannungen der Halbleiterschalter erforderlich sind. Damit führt jeweils vor und nach dem Nulldurchgang des Laststroms der jeweils andere Teil den Strom durch die Parallelschaltung. Durch das verhältnismäßig geringe di/dt des Laststroms (einige A/µs) bleibt ausreichend Zeit, dass auch eine übergeordnete Elektronik, die ansonsten zu Regelungsaufgaben benutzt wird, die Stromrichtungserkennung übernehmen kann. Somit können auch mehrere RC-IGBT im IGBT-Modus oder herkömmliche IGBT, die parallel angeordnet sind, getrennt angesteuert werden. Dadurch lässt sich auch im IGBT-Modus die Ladungsträgermenge paralleler IGBTs einstellen und Ausschaltverluste reduzieren. Auch ein zu hohes di/dt bei kleinen Lastströmen kann durch das getrennte Ansteuern verhindert werden. Dazu werden immer nur so viele RC-IGBTs im IGBT-Modus oder Standard IGBTs bei kleinen Lastströmen mit positiver Gate-Emitter-Spannung angesteuert, wie für den Stromfluss benötigt werden. Dies hebt die Stromdichte in den stromführenden IGBTs.

Neben der Ansteuerung der ersten Halbleiterschalter und der zweiten Halbleiterschalter mit Spannungen, die ein unterschiedliches Vorzeichen aufweisen, ist es ebenfalls möglich, die ersten Halbleiterschalter und die zweiten Halbleiterschalten mit einer Spannung mit gleichem Vorzeichen und unterschiedlichem Betrag anzusteuern. Damit kann die Stromaufteilung auf die einzelnen Halbleiterschalter der Parallelschaltung optimiert werden. Beispielsweise können somit Halbleiterschalter, die eine bessere Kühlung erfahren einen höheren Strom zugeteilt bekommen und andere Halbleiterschalter mit schlechterer Kühlung einen geringeren Strom.

Besonders vorteilhaft ist der Einsatz eines solchen Schaltelementes, wenn zwei dieser Schaltelemente in einer Reihenschaltung angeordnet werden und damit einen Stromrichter mit einer Phase ergeben. Der Verbindungspunkt der Reihenschaltung ist dabei der Lastanschluss, durch den der Laststrom fließt. Der Lastanschluss kann dann mit dem einen Ende oder dem anderen Ende des Phasenmoduls elektrisch verbunden werden. An den beiden Enden der Reihenschaltung ist ein Zwischenkreiskondensator angeordnet. Damit weisen die beiden Enden üblicherweise, d.h. sobald der Kondensator auf eine Spannung aufgeladen ist, unterschiedliche elektrische Potentiale auf. Diese Potentiale werden auch als Zwischenkreispotentiale bezeichnet. Beispielsweise durch eine Pulsweitenmodulation lässt sich am Lastanschluss im zeitlichen Mittel ein beliebiges elektrisches Potential generieren, welches zwischen den beiden Zwischenkreispotentialen liegt. Somit ist auf einfache Weise eine Phase eines Stromrichters oder, bei Verwendung mehrerer Phasen, ein mehrphasiger Stromrichter einfach und kostengünstig realisierbar.

Bei einer vorteilhaften Ausgestaltung der Erfindung wird zumindest zeitweise mindestens ein erster Halbleiterschalter der mindestens zwei rückwärts leitfähigen Halbleiterschalter mit einer negativen Spannung angesteuert und mindestens ein zweiter Halbleiterschalter der mindestens zwei rückwärts leitfähigen Halbleiterschalter wird mit einer positiven Spannung angesteuert. Hiermit sind alle zuvor genannten Vorteile realisierbar. Durch das unterschiedliche Vorzeichen ist eindeutig festgelegt, welche Halbleiterschalter in der Parallelschaltung einen Strom führen und welche nicht. Damit lässt sich die Aufteilung der Ströme auf die einzelnen parallelen Halbleiterschalter auf einfache Weise bestimmen. Ein weiterer Vorteil, vor einem bevorstehenden Richtungswechsel, auch als Vorzeichenwechsel bezeichnet, des Laststroms nur einen Teil der Halbleiterschalter für das Führen des Stromes zu nutzen, besteht darin, dass der Strom dann in den einzelnen genutzten Halbleiterschaltern höher ist, als wenn der Strom durch alle parallel angeordneten Halbleiterschalter fließt. Damit kann gleichzeitig verhindert werden, dass der Strom durch einen Halbleiterschalter einen Minimalwert unterschreitet und abreißt. Durch die Ansteuerung kann der Bereich eines möglichen Abreißens des Diodenstroms zu kleineren Lastströmen hin verschoben werden und verliert dadurch erheblich an Bedeutung.

Bei einer weiteren vorteilhaften Ausgestaltung der Erfindung weist die Parallelschaltung eine Vielzahl von rückwärts leitfähigen Halbleiterschaltern auf, wobei die Anzahl der ersten Halbleiterschalter und/oder die Anzahl der zweiten Halbleiterschalter in Abhängigkeit vom Laststrom bestimmt wird. Dabei kann zu jedem Zeitpunkt die Anzahl der an der Stromführung beteiligten Halbleiterschalter derart angepasst werden, dass diese nicht aufgrund eines zu hohen Stromes überlastet werden. Gleichzeitig wird ein so hoher Strom (Mindeststrom) sichergestellt, dass es nicht zu einem Abreißen des Stroms aufgrund des snapping-Verhaltens kommt. Der RC-IGBT muss, sofern er einen Strom tragen soll, je nach Stromrichtung immer mit der zugehörigen Ansteuerspannung an der Gate-Emitter-Strecke angesteuert werden. Andernfalls wird entweder der RC-IGBT im IGBT-Modus bei negativer Gate-Emitter-Spannung nicht einschalten, oder im Dioden-Modus bei positiver Gate-Emitter-Spannung durch Stromkonzentration auf einzelne Chips oder Bereiche von Chips beschädigt. Durch eine Stromrichtungserkennung muss sehr nahe am natürlichen Stromnulldurchgang des Laststromes/ RC-IGBT-Stromes die richtige Gate-Emitter-Spannung eingestellt werden. Im Parallelbetrieb von zwei oder mehr RC-IGBT kann in der Nähe des Stromnulldurchganges ein oder mehrere RC-IGBT mit positiver und ein oder mehrere RC-IGBT mit negativer Gate-Emitter-Spannung angesteuert werden. Fließt jetzt der Strom in Dioden-Richtung wird der RC-IGBT mit negativer Gate-Emitter-Spannung diesen Strom übernehmen. Der RC-IGBT mit positiver Gate-Emitter-Spannung wird sich auf Grund seiner viel höheren Durchlass-Spannung nicht am Stromfluss beteiligen. Umgekehrt wird bei einem Stromfluss in IGBT-Richtung (von C nach E) nur der RC-IGBT mit positiver Gate-Emitter-Spannung den Strom führen. Erst wenn der Laststrom soweit angestiegen ist, dass beide bzw. alle RC-IGBT zur Stromführung gebraucht werden, muss die Gate-Emitter-Spannung aller benötigen RC-IGBT gleich eingestellt sein, entsprechend der Stromrichtung. Damit kann die Stromrichtungserkennung erheblich vereinfacht werden, weil die Anforderung an die Genauigkeit stark reduziert werden kann. Es hat sich gezeigt, dass eine bereits für regelungstechnische Zwecke vorhandene Strommesseinrichtung diese Aufgabe übernehmen kann.

Bei einer weiteren vorteilhaften Ausgestaltung der Erfindung befinden sich die rückwärts leitfähigen Halbleiterschalter der Parallelschaltung im Dioden-Modus befinden, wobei bis zu einem ersten Zeitpunkt t₁ alle in der Parallelschaltung angeordneten rückwärts leitfähigen Halbleiterschalter mit einer negativen Spannung angesteuert werden, wobei nach dem ersten Zeitpunkt t₁ und vor einem zweiten Zeitpunkt t₂ die ersten Halbleiterschalter der in der Parallelschaltung angeordneten rückwärts leitfähigen Halbleiterschalter mit einer negativen Spannung angesteuert werden und die zweiten Halbleiterschalter der in der Parallelschaltung angeordneten rückwärts leitfähigen Halbleiterschalter mit einer positiven Spannung angesteuert werden, wobei der erste Zeitpunkt t₁ vor dem zweiten Zeitpunkt t₂ liegt, wobei der zweite Zeitpunkt t₂ einem Zeitpunkt entspricht, an dem der Laststrom von den rückwärts leitfähigen Halbleiterschaltern abkommutiert ist. Durch getrennte Ansteuerkanäle können parallele RC-IGBTs im DiodenModus mit verschiedenen Gate-Emitter-Spannungen angesteuert werden. Die Ansteuerung wird so gewählt, dass bei kleinen Lastströmen einem zulässiger Teil der parallelen RC-IGBT ab einer gewissen Zeit t₁ vor der bevorstehenden Kommutierung eine positive Gate-Emitter-Spannung zugeführt wird (Entsättigungspuls) und dem restlichen Teil der RC-IGBT im Dioden-Modus erst ab einer Zeit t₂. Im Zeitraum zwischen t₁ und t₂ verlagert sich der Laststrom auf die RC-IGBTs im Dioden-Modus, die noch keine positive Gate-Emitter-Spannung aufweisen. Somit wird ein Teil der parallelen RC-IGBTs im Dioden-Modus entlastet und baut seine gespeicherte Ladung bereits zu diesem Zeitpunkt ab. Bei der Kommutierung muss nur noch erheblich weniger gespeicherte Ladung abgebaut werden. Auch ein "Abreißen" des Stromes kann so wiederum verhindert werden.

Bei einer weiteren vorteilhaften Ausgestaltung der Erfindung weist die Parallelschaltung mindestens drei rückwärts leitfähige Halbleiterschalter auf, die sich im Dioden-Modus befinden, wobei mit sinkendem Betrag des Laststromes die Ansteuerung mindestens eines dritten Halbleiterschalters der rückwärts leitfähigen Halbleiterschalter sich von einer negativen Spannung zu einer positiven Spannung ändert. Durch das Schalten bei sinkendem Strombetrag kann sichergestellt werden, dass, insbesondere bei sinusförmigen Strömen, eine Überlastung durch einen kurzfristigen und unerwarteten Stromanstieg vermieden wird. Durch den sinkenden Betrag kann darüber hinaus sichergestellt werden, dass in den leitenden Halbleiterschaltern sich ein Strom in einem Bereich einstellt, bei dem ein Schaden an einem der leitenden Halbleiterschalter sicher ausgeschlossen ist.

Bei einer weiteren vorteilhaften Ausgestaltung der Erfindung wird bei einem bevorstehenden Wechsel der rückwärts leitfähiger Halbleiterschalter vom Dioden-Modus in den IGBT-Modus, insbesondere zum Zeitpunkt eines Nulldurchgangs des Laststromes, genau ein rückwärts leitfähiger Halbleiterschalter mit einer negativen Spannung angesteuert und die übrigen Halbleiterschalter der in der Parallelschaltung angeordneten Halbleiterschalter werden mit einer positiven Spannung angesteuert. Durch den kleiner werdenden Laststrom und den damit kleiner werdenden Strom durch die Parallelschaltung wird zu einem Zeitpunkt ein Stromwert erreicht, bei dem ein einzelner Halbleiterschalter in der Lage ist, diesen Strom zu führen. Die übrigen Halbleiterschalter können mittels einer positiven Spannung bereits auf den Zustand IGBT-Modus vorbereitet werden. Damit ist die genaue Kenntnis des Wechsels zwischen den Modi nicht mehr erforderlich.

Bei einer weiteren vorteilhaften Ausgestaltung der Erfindung erfolgt die Ansteuerung der unterschiedlichen rückwärts leitfähigen Halbleiterschalter zumindest zeitweise zeitversetzt zueinander. Eine einfache Möglichkeit, die Schalthandlungen nicht gleichzeitig sondern nacheinander stattfinden zu lassen, besteht darin, einen festen zeitlichen Versatz zwischen den Ansteuerspannungen der einzelnen parallelen rückwärts leitfähigen Halbleiterschalter vorzusehen. Alternativ kann der zeitliche Versatz auch abhängig von dem Wert des Laststromes, insbesondere von dem Betrag, der Frequenz oder der Phasenlage des Lastromes gestaltet werden. Durch den zeitlichen Versatz kann ein Abreißen des Stromes insbesondere im Dioden-Betrieb zuverlässig vermieden werden. Dabei kann die Abhängigkeit aufgrund eines gemessenen oder geschätzten Stromwertes erfolgen. Gerade bei einem sinusförmigen Verlauf kann der Stromverlauf hinreichend gut, beispielsweise für die nächste halbe oder ganze Periodendauer, abgeschätzt werden, so dass auf die Auswertung genauer Messwerte verzichtet werden kann.

Durch die zeitversetzte Ansteuerung entstehen die Schaltverluste in einem zeitlichen Versatz, so dass die entstehende Wärme besser abgeführt werden kann. Darüber hinaus kann die Entstehung von Verlusten beeinflusst werden. Dabei hat es sich als vorteilhaft erwiesen, einen hohen Strom durch einen Halbleiterschalter abzuschalten anstatt einen mittleren Strom durch zwei Halbleiterschalter abzuschalten. Somit können durch das zeitversetzte Schalten in Summe Schaltverluste verringert werden.

Im Folgenden wird die Erfindung anhand der in den Figuren dargestellten Ausführungsbeispiele näher beschrieben und erläutert. Es zeigen:
- FIG 1: eine rückwärts leitfähiger IGBT (RC-IGBT)
- FIG 2: ein Schaltelement,
- FIG 3: einen zeitlich Verlauf einer Ansteuerung von parallel RC-IGBTs
- FIG 4: einen Stromrichter und
- FIG 5: einen zeitlich Verlauf einer Ansteuerung bei einer Kommutierung

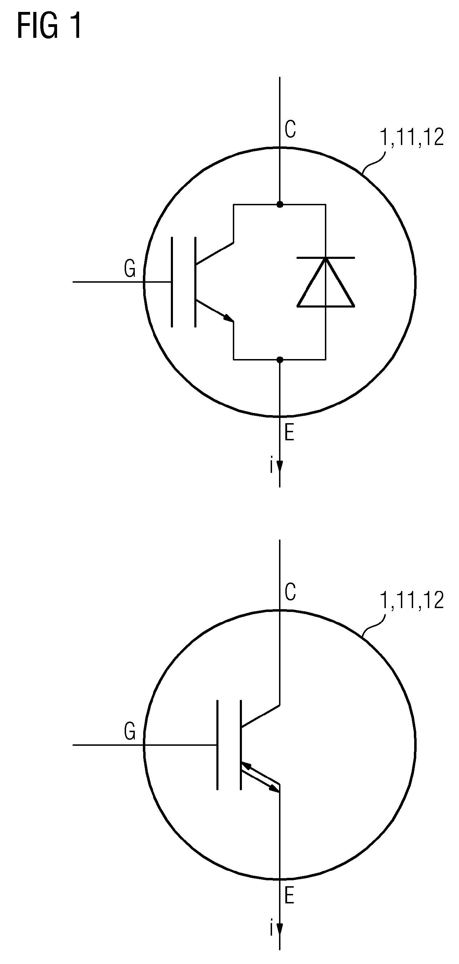

FIG 1 zeigt im oberen Teil die funktionale Darstellung eines rückwärts leitfähigen Halbleiterschalters 1, ausgeführt als RC-IGBT. Zwischen dem Kollektor C und dem Emitter E befindet sich eine Parallelschaltung aus IGBT und Diode. Diese Parallelschaltung ist auf einem Chip angeordnet. Dies hat zur Folge, dass mit dem Gate-Anschluss, insbesondere mit der angelegten Spannung zwischen Gate G und Emitter E nicht nur das Verhalten des IGBT-Schalters, sondern auch das Verhalten der Diode beeinflussbar ist. Abhängig davon, ob der Halbleiterschalter 1 mit einer positiven oder mit einer negativen Spannung zwischen Gate G und Emitter E angesteuert wird, gehört er zur Gruppe der ersten Halbleiterschalter 11 (negative Ansteuerung) oder zur Gruppe der zweiten Halbleiterschalter 12 (positive Ansteuerung). Der Strom i durch den RC-IGBT wird so definiert, dass ein Stromfluss von Kollektor C zu Emitter E ein positives Vorzeichen hat. Somit sind ein RC-IGBT mit positivem Strom i im IGBT-Modus und ein RC-IGBT mit negativem Strom i im Dioden-Modus. Im unteren Teil ist das Schaltzeichen eines RC-IGBTs angegeben, der die oben beschriebenen Funktionen aufweist.

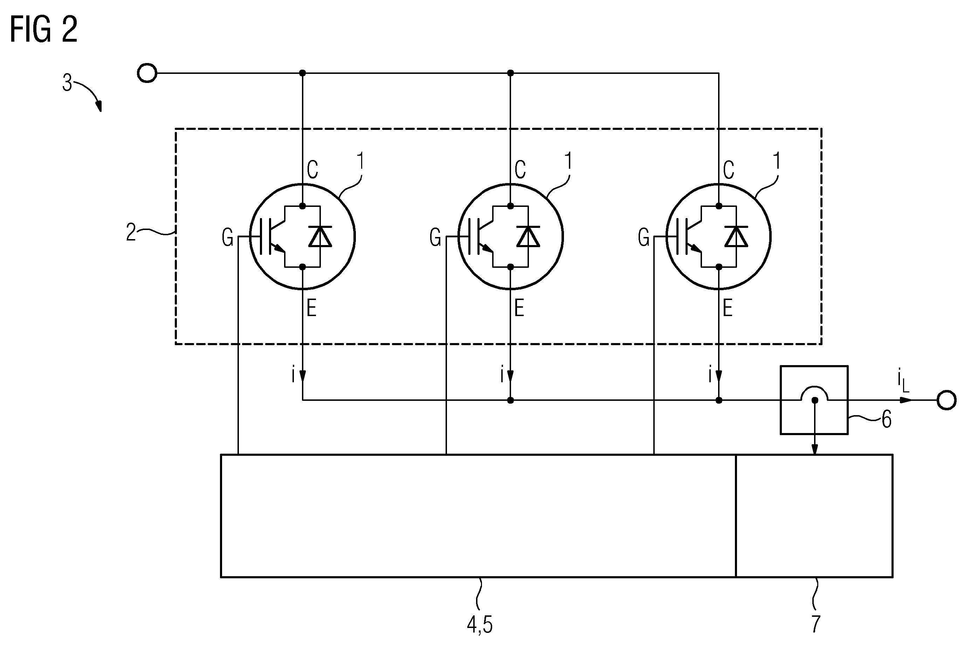

FIG 2 zeigt ein Schaltelement 3 mit einer Parallelschaltung 2 aus drei Halbleiterschaltern 1. Die Halbleiterschalter 1, ausgeführt als RC-IGBTs, werden über ihren Gate-Anschluss G durch die Ansteuereinheit 4 bzw. Teile 5 der Ansteuereinheit 4 angesteuert. Die Ansteuereinheit 4 bzw. die Teile 5 der Ansteuereinheit 4 generiert ihre Ansteuerbefehle auf der Basis von Signalen aus der Regelungsbaugruppe 7. In die Regelungsbaugruppe 7 gehen wiederum Messwerte des Stromsensors 6 ein, der den Laststrom i_{L} misst. Der Laststrom i_{L} setzt sich zusammen als Summe aus den Strömen i durch die einzelnen parallelen Halbleiterschalter 1.

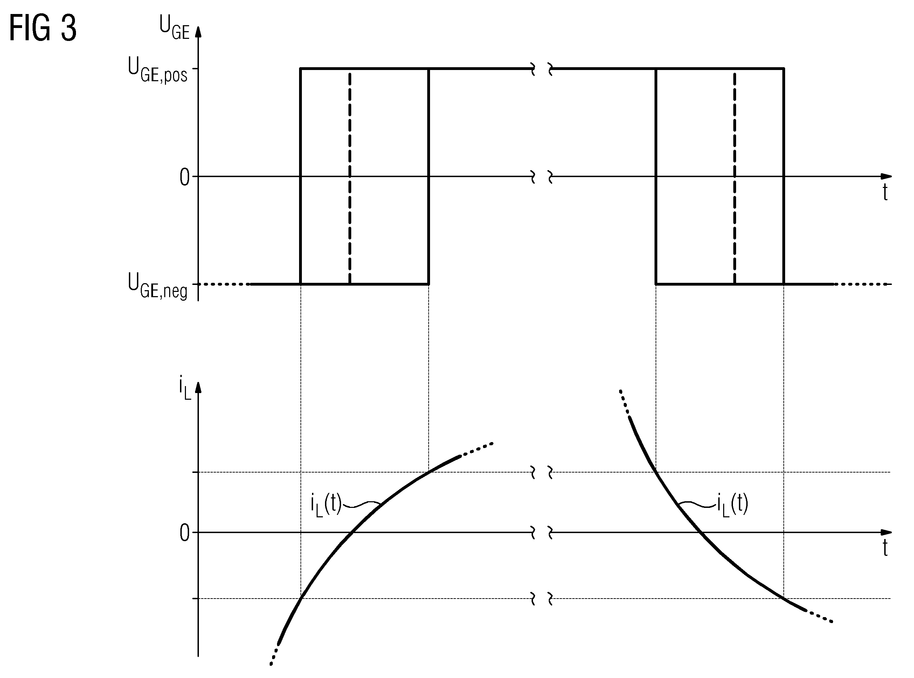

FIG 3 zeigt den zeitlichen Verlauf der Ansteuerspannung U_{GE} und des Laststromes i_{L} in Abhängigkeit von der Zeit t für eine Parallelschaltung 2 aus drei Halbleiterschaltern 1. Diese Zeitverläufe können somit beispielsweise einem Betrieb des in FIG 2 dargestellten Schaltelementes 3 entsprechen. Bei negativem Laststrom i_{L}, wie auf der linken Seite der FIG 3 dargestellt, befinden sich die dort dargestellten Halbleiterschalter 1 im Dioden-Modus, da die Diode im Innern des RC-IGBTs das Führen des Stroms i übernimmt. Mit kleiner werdendem Betrag des Stromes i_{L} werden nicht mehr alle drei Halbleiterschalter 1 zum Führen des Stromes benötigt. Es ist in diesem Fall möglich, dass zwei der Halbleiterschalter 1 den Strom führen, ohne überlastet zu werden. Diese beiden Halbleiterschalter 1 werden dann als erster Halbleiterschalter 11 bezeichnet. Der in dieser Parallelschaltung 2 noch vorhandene zusätzliche Halbleiterschalter 1 wird für das Führen des Stromes nicht benötigt und kann mittels einer positiven Ansteuerspannung U_{GE,pos} angesteuert werden, so dass er keinen oder nur noch einen geringen Strom führt. Durch die positive Ansteuerung dieses Halbleiterschalters 1 wird er als zur Gruppe der zweiten Halbleiterschalter 12 zugehörig bezeichnet. Sinkt der Betrag des Stromes i_{L} weiter ab, so kann einer der ersten Halbleiterschalter ebenfalls eine positive Ansteuerspannung annehmen, so dass er den Laststrom nicht mehr trägt. In diesem Fall ist dann nur noch ein Halbleiterschalter 1 in der Gruppe der ersten Halbleiterschalter 11 vertreten. Der Betrag des Laststromes i_{L} ist dann derart gering, dass nur dieser eine Halbleiterschalter 1 für das Führen des gesamten Laststroms i_{L} ausreicht. Die beiden übrigen Halbleiterschalter 1 sind nun in der Gruppe der zweiten Halbleiterschalter 12 und erfahren eine positive Ansteuerung am Gate G. Damit sind sie im Dioden-Modus nicht stromführend. Erreicht nun der Laststrom i_{L} den Betrag Null, d.h. er schneidet auf dem Diagramm die Zeitachse t, so wechseln die Halbleiterschalter 1 vom Dioden-Modus in den IGBT-Modus. Die bereits mit einer positiven Ansteuerspannung vorhandenen Halbleiterschalter 1 der Gruppe der zweiten Halbleiterschalter 12 übernehmen nun den Laststrom i_{L}. Damit ist ein Umschalten des letzten verbliebenen ersten Halbleiterschalters 11 zum Zeitpunkt des Nulldurchgangs nicht erforderlich und kann später erfolgen, da die Halbleiterschalter 1 der Gruppe der zweiten Halbleiterschalter 12 den Strom zum Zeitpunkt des Null-Durchgangs problemlos und ohne eine Gefahr der Beschädigung übernehmen können. Eine Ansteuerung des Halbleiterschalters 1 mit negativer Ansteuerspannung kann nun nach dem Vorzeichenwechsel des Laststroms i_{L}, d.h. nachdem der Laststrom positive Werte angenommen hat, erfolgen.

Der rechte Teil der FIG 3 zeigt den Übergang vom IGBT-Modus in den Dioden-Modus. Mit kleiner werdendem Betrag des Stromes i_{L} werden auch hier nicht mehr alle drei Halbleiterschalter 1 zum Führen des Stromes benötigt. Es ist in diesem Fall möglich, dass zwei der Halbleiterschalter 1 den Strom führen, ohne überlastet zu werden. Der in dieser Parallelschaltung 2 noch vorhandene zusätzliche Halbleiterschalter 1 wird für das Führen des Stromes nicht benötigt und kann mittels einer negativen Ansteuerspannung U_{GE,neg} angesteuert werden, so dass er keinen oder nur noch einen geringen Strom führt. Sinkt der Betrag des Stromes i_{L} weiter ab, so kann ein weiterer Halbleiterschalter ebenfalls eine negative Ansteuerspannung angelegt bekommen, so dass er den Laststrom nicht mehr trägt. In diesem Fall ist dann nur noch ein Halbleiterschalter 1 stromführend. Erreicht nun der Laststrom i_{L} den Betrag Null, d.h. er schneidet auf dem Diagramm die Zeitachse t, so wechseln die Halbleiterschalter 1 vom IGBT-Modus in den Dioden-Modus. Die bereits mit einer negativen Ansteuerspannung angesteuerten Halbleiterschalter 1 übernehmen nun den Laststrom i_{L}. Damit ist ein Umschalten zum genauen Zeitpunkt des Vorzeichenwechsels des Laststroms i_{L} und damit die genaue Kenntnis über den Augenblick des Nulldurchgangs nicht mehr erforderlich.

Um den Ansteueraufwand klein zu halten, können aber auch zwei der hier dargestellten drei Halbleiter zu einem Zeitpunkt auf positive Gate-Spannung umgeschaltet werden, sobald der Laststrom von dem einen verbleibenden Halbleiter mit negativer Gate-Spannung geführt werden kann. Aus diesem Grund ist in der FIG 3 die jeweils mittlere Schalthandlung gestrichelt dargestellt, da sie gegebenenfalls, wenn der Betrag des Stroms bereits hinreichend klein ist, mit der vorangehenden Schalthandlung gleichzeitig erfolgen kann.

Durch das zeitversetzte Schalten ist die genaue Kenntnis des Nulldurchgangs des Laststromes i_{L} nicht mehr erforderlich. Sowohl vor als auch nach dem Nulldurchgang kann der Laststrom i_{L} von Halbleiterschaltern 1 der Reihenschaltung 2 geführt werden. Damit entfällt eine bei RC-IGBTs ansonsten oft anzutreffende genaue Erfassung des Strom-Null-Durchgangs bei dem alle RC-IGBTs die Ansteuerspannung am Gate ändern. Darüber hinaus wird durch die Verteilung des Laststromes i_{L} auf nur wenige bzw. nur einen Halbleiterschalter 1 sichergestellt, dass der Strom durch den Halbleiterschalter 1 hinreichend groß ist, um ein Abreißen des Stroms zu verhindern. Ebenso ist es möglich, dieses Verfahren, d.h. das zeitversetzte Ansteuern der einzelnen Halbleiterschaltern 1 einer Parallelschaltung 2 auch für den Übergang vom IGBT-Modus in den Dioden-Modus vorzusehen. Dabei werden die Spannungen zur Ansteuerung sukzessive von einer positiven Ansteuerung U_{GE,pos} zu einer negativen Ansteuerspannung U_{GE,neg} verändert.

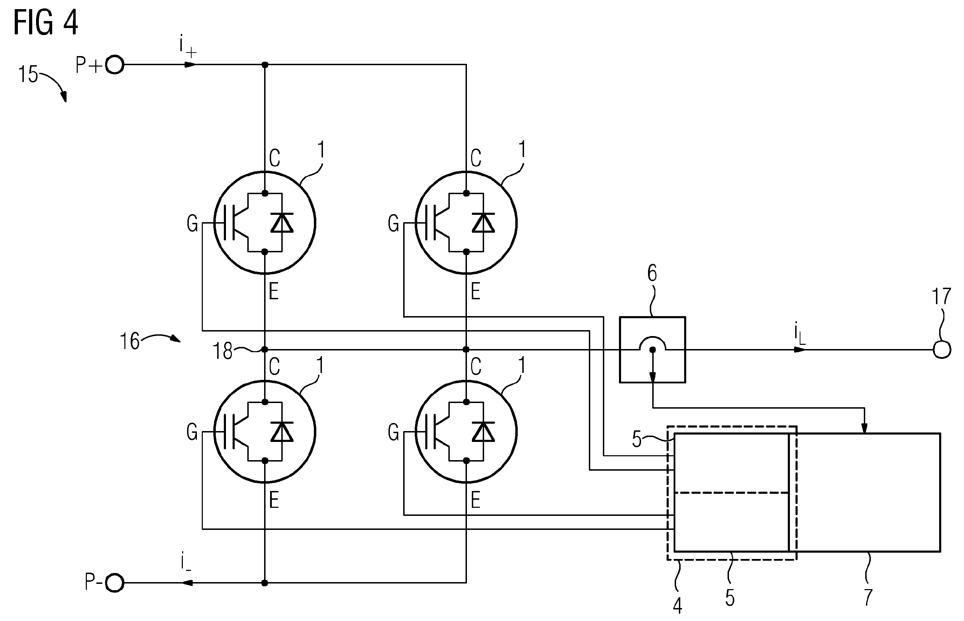

FIG 4 zeigt ein Ausführungsbeispiel eines Stromrichters 15 mit einer Reihenschaltung 16 aus zwei Parallelschaltungen 2, wobei die einzelnen Parallelschaltungen 2 jeweils zwei Halbleiterschalter 1 aufweisen. Der Verbindungspunkt 18 der Reihenschaltung bildet den Phasenanschluss 17. Im Phasenanschluss 17 ist ein Stromsensor 6 zur Messung des Laststromes i_{L} angeordnet. Der Stromsensor 6 übergibt seine Messwerte an eine Regelungsbaugruppe 7. Die Regelungsbaugruppe 7 ist mit einer Ansteuereinheit 4 verbunden. Die Ansteuereinheit 4 wird in diesem Ausführungsbeispiel durch zwei Teile 5 einer Ansteuereinheit 4 gebildet. Ein erster Teil 5 der Ansteuereinheit 4 steuert die Halbleiterschalter 1 an, die mit einem positiven Zwischenkreispotential P+ verbunden sind. Ein weiterer Teil 5 der Ansteuereinheit 4 steuert die Halbleiterschalter 1 an, die mit dem negativen Potential P- des Zwischenkreises verbunden sind. Die gekennzeichneten Ströme i+ sowie i- fließen in den jeweiligen Halbleiterschaltern 1 vom Kollektor zum Emitter. Somit stellt ein positiver Strom i+ und i- einen Betrieb im IGBT-Modus und ein negativer Strom von i+ und i- einen Betrieb im Dioden-Modus des jeweiligen Halbleiterschalters 1 dar. Der hier dargestellte Stromrichter 15 kann um weitere Phasen mit jeweils weiteren Phasenanschlüssen 17 erweitert werden, wobei die weiteren Phasen auch durch die Regelungsbaugruppe 7 geregelt und gesteuert werden können. Die einzelnen Phasen werden an ihren Zwischenkreispotentialen P+ und P- miteinander verbunden. Häufig weisen Stromrichter 15 drei Phasenanschlüsse 17 für ein Drehstromsystem auf. Weiter ist es möglich, mit zwei Phasenanschlüssen einen Phasenanschluss für eine Phase und einen zweiten Phasenanschluss für einen Nullleiter vorzusehen.

Um eine am Phasenanschluss 17 angeschlossene Last mit elektrischer Energie zu versorgen, wird der Phasenanschluss 17 mit einem der beiden Zwischenkreispotentiale P+ oder P- verbunden. Dies geschieht über die jeweilige Parallelschaltung 2 von Halbleiterschaltern 1. Hierbei kommt beispielsweise eine Pulsweitenmodulation zum Einsatz. Somit sind entweder die mit der positiven Zwischenkreispotential P+ verbundenen Halbleiterschalter 1 leitend oder die mit dem negativen Potential P-verbundenen Halbleiterschalter 1 leitend. Der Zustand, dass sowohl die mit dem positiven Potential verbundenen Halbleiterschalter als auch die mit dem negativen Potential verbundenen Halbleiterschalter leitend sind, muss unbedingt vermieden werden, da es sonst zu einem Kurzschluss im Zwischenkreis kommt, bei dem die beiden Potentiale P+ und P- verbunden werden. Dies würde zu hohen Kurzschlussströmen führen. Das Umschalten der Leitfähigkeit zwischen den Halbleiterschaltern 1, die mit dem positiven Zwischenkreispotential P+ verbunden sind und den Halbleiterschaltern 1 die mit dem negativen Potential P- des Zwischenkreises verbunden sind, wird als Kommutieren bezeichnet. Der Vorgang des Ausschaltens wird dabei als Abkommutieren bezeichnet.

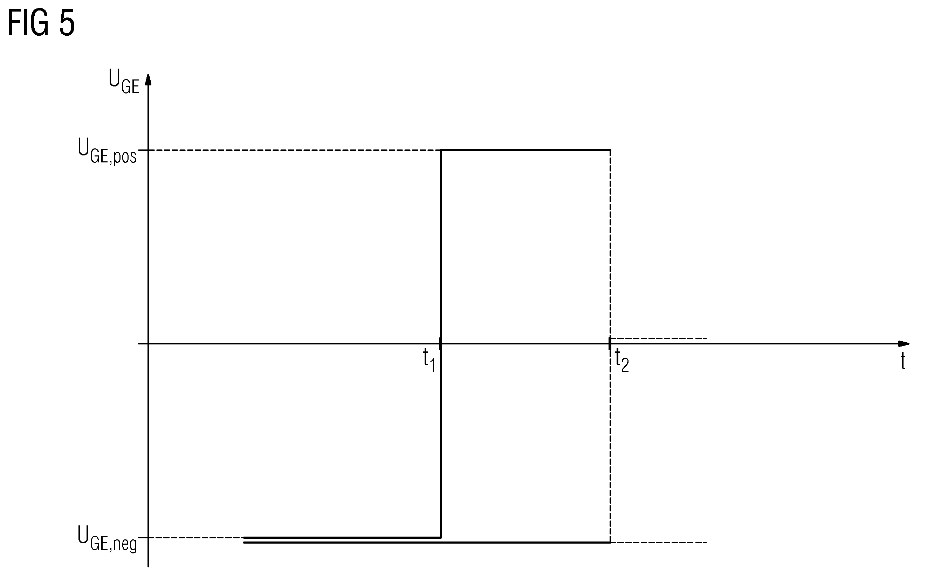

FIG 5 zeigt den zeitlichen Verlauf der Ansteuerung der Halbleiterschalter 1 der Parallelschaltung 2 während einer Kommutierung bei einer Anordnung nach FIG 4. Dabei befinden sich die Halbleiterschalter 1 aus der Parallelschaltung 2 im Dioden-Modus. Dies ist bei den mit dem positiven Potential P+ des Zwischenkreises verbundenen Halbleiterschaltern 1 der Fall, wenn der Laststrom i_{L} negativ ist oder bei den Halbleiterschaltern 1, die mit dem negativen Potential P- des Zwischenkreises verbunden sind der Fall, wenn der Laststrom i_{L} positiv ist. Die Halbleiterschalter 1 werden, um den Dioden-betrieb realisieren zu können, mit einer negativen Ansteuerspannung U_{GE,neg} gesteuert. Zu einem Zeitpunkt t₁ wechselt die Ansteuerung zumindest eines Halbleiterschalters 1 von einer negativen Spannung zu einer positiven Spannung. Sollten die Parallelschaltung 2 mehr als zwei Halbleiterschalter 1 aufweisen, können nacheinander oder gleichzeitig (weniger Ansteueraufwand) mehrere Halbleiterschalter 1 ihre Ansteuerspannung von einer negativen Spannung zu einer positiven Spannung ändern. Es verbleiben nur so viele Halbleiterschalter 1 mit negativer Spannung angesteuert, die erforderlich sind, um den Laststrom i_{L} zu führen. Dies gewährleistet auch, dass ein Abreißen des Stromes i durch den Halbleiterschalter 1 sicher vermieden wird. Zum Zeitpunkt t₂, der zeitlich später liegt als t₁, soll die Kommutierung auf die jeweiligen anderen Halbleiterschalter der Reihenschaltung erfolgen. Die dann im Dioden-Modus befindlichen Halbleiterschalter geben den Strom ab. Dabei muss dann sichergestellt werden, dass diese Halbleiterschalter 1 der Parallelschaltung 2 nicht mit einer positiven Ansteuerspannung angesteuert werden. Dies ist deshalb zu vermeiden, da die Halbleiterschalter des anderen Teils der Reihenschaltung, die dann im IGBT Modus betrieben werden, nach der Kommutierung mit einer positiven Gate-Spannung angesteuert werden. Somit dürfen die Halbleiterschalter, bei denen der Strom abkommutiert ist, nicht mehr mit einer positiven Gate-Spannung angesteuert werden, da es sonst zu einem Kurzschluss im Zwischenkreis kommen könnte. Es ist möglich, die Halbleiterschalter 1 von denen der Strom abkommutiert ist, mit einer beliebigen negativen Spannung oder auch mit der Spannung 0 anzusteuern.

Zusammenfassend betrifft die Erfindung ein Verfahren zur Ansteuerung mindestens zweier rückwärts leitfähiger Halbleiterschalter, wobei die mindestens zwei rückwärts leitfähigen Halbleiterschalter in einer Parallelschaltung angeordnet sind. Zur Verbesserung des Schaltverhaltens wird vorgeschlagen, zumindest zwei der in einer Parallelschaltung angeordneten rückwärts leitfähigen Halbleiterschalter zumindest zeitweise mit einer unterschiedlichen Spannung anzusteuern. Die Erfindung betrifft weiter Schaltelement mit zwei in einer Parallelschaltung angeordneten rückwärts leitfähigen Halbleiterschalter und einer Ansteuereinheit oder zumindest einem Teil einer Ansteuereinheit zur Ansteuerung der rückwärts leitfähigen Halbleiterschalter, wobei ein Stromsensor zur Erfassung eines durch die Parallelschaltung fließenden Laststroms mit einer Regelungsbaugruppe zur Auswertung von Messwerten des Stromsensors verbindbar ist, wobei mittels der Ansteuereinheit oder mittels des Teils der Ansteuereinheit die einzelnen rückwärts leitfähigen Halbleiterschalter jeweils mit unterschiedlichen Spannungen ansteuerbar sind.

## Patentansprüche

1. Verfahren zur Ansteuerung mindestens zweier rückwärts leitfähiger Halbleiterschalter (1), wobei die mindestens zwei rückwärts leitfähigen Halbleiterschalter (1) in einer Parallelschaltung (2) angeordnet sind, wobei zumindest zwei der rückwärts leitfähigen Halbleiterschalter (1) zumindest zeitweise mit einer unterschiedlichen Spannung angesteuert werden.

2. Verfahren zur Ansteuerung nach Anspruch 1, wobei zumindest zeitweise mindestens ein erster Halbleiterschalter (11) der mindestens zwei rückwärts leitfähigen Halbleiterschalter (1) mit einer negativen Spannung angesteuert wird und mindestens ein zweiter Halbleiterschalter (12) der mindestens zwei rückwärts leitfähigen Halbleiterschalter (1) mit einer positiven Spannung angesteuert wird.

3. Verfahren zur Ansteuerung nach Anspruch 2, wobei die Parallelschaltung (2) eine Vielzahl von rückwärts leitfähigen Halbleiterschaltern (1) aufweist, wobei die Anzahl der ersten Halbleiterschalter (11) und/oder die Anzahl der zweiten Halbleiterschalter (12) in Abhängigkeit vom Laststrom (i_{L}) bestimmt wird.

4. Verfahren zur Ansteuerung nach Anspruch 2 oder 3, wobei sich die rückwärts leitfähigen Halbleiterschalter (1) der Parallelschaltung (2) im Dioden-Modus befinden, wobei bis zu einem ersten Zeitpunkt (t₁) alle in der Parallelschaltung (2) angeordneten rückwärts leitfähigen Halbleiterschalter (1) mit einer negativen Spannung angesteuert werden, wobei nach dem ersten Zeitpunkt (t₁) und vor einem zweiten Zeitpunkt (t₂) die ersten Halbleiterschalter (11) der in der Parallelschaltung (2) angeordneten rückwärts leitfähigen Halbleiterschalter (1) mit einer negativen Spannung angesteuert werden und die zweiten Halbleiterschalter (12) der in der Parallelschaltung (2) angeordneten rückwärts leitfähigen Halbleiterschalter (1) mit einer positiven Spannung angesteuert werden, wobei der erste Zeitpunkt (t₁) vor dem zweiten Zeitpunkt (t₂) liegt, wobei der zweite Zeitpunkt (t₂) einem Zeitpunkt entspricht, an dem der Laststrom (i_{L}) von den rückwärts leitfähigen Halbleiterschaltern (1) abkommutiert ist.

5. Verfahren zur Ansteuerung nach einem der Ansprüche 2 bis 4, wobei die Parallelschaltung (2) mindestens drei rückwärts leitfähige Halbleiterschalter (1) aufweist, die sich im Diodenmodus befinden, wobei mit sinkendem Betrag des Laststromes (i_{L}) die Ansteuerung mindestens eines dritten Halbleiterschalters (13) der rückwärts leitfähigen Halbleiterschalter (1) sich von einer negativen Spannung zu einer positiven Spannung ändert.

6. Verfahren nach einem der Ansprüche 1 bis 5, wobei bei einem bevorstehenden Wechsel der rückwärts leitfähiger Halbleiterschalter (1) vom Dioden-Modus in den IGBT-Modus, insbesondere zum Zeitpunkt eines Nulldurchgangs des Laststromes (i_{L}), genau ein rückwärts leitfähiger Halbleiterschalter (11) mit einer negativen Spannung angesteuert wird und die übrigen Halbleiterschalter (12) der in der Parallelschaltung (2) angeordneten Halbleiterschalter (1) mit einer positiven Spannung angesteuert werden.

7. Verfahren nach einem der Ansprüche 1 bis 6, wobei die Ansteuerung der unterschiedlichen rückwärts leitfähigen Halbleiterschalter (1) zumindest zeitweise zeitversetzt zueinander erfolgt.

8. Schaltelement (3), aufweisend
- mindestens zwei in einer Parallelschaltung (2) angeordnete rückwärts leitfähigen Halbleiterschalter (1)
- eine Ansteuereinheit (4) oder zumindest ein Teil (5) einer Ansteuereinheit (4) zur Ansteuerung der rückwärts leitfähigen Halbleiterschalter (1),
wobei ein Stromsensor (6) zur Erfassung eines durch die Parallelschaltung (2) fließenden Laststroms (i_{L}) mit einer Regelungsbaugruppe (7) zur Auswertung von Messwerten des Stromsensors (6) verbindbar ist, wobei mittels der Ansteuereinheit (4) oder mittels des Teils (5) der Ansteuereinheit (4) die einzelnen rückwärts leitfähigen Halbleiterschalter (1) jeweils mit unterschiedlichen Spannungen ansteuerbar sind.

9. Stromrichter (15) aufweisend
- mindestens eine Reihenschaltung (16) aus mindestens zwei Schaltelementen (3) nach Anspruch 8 und
- eine Regelungsbaugruppe (7) zur Auswertung von Messwerten des Stromsensors (6),
- einen Phasenanschluss (17) zum Anschluss einer Last,
wobei ein Verbindungspunkt (18) der zwei Schaltelemente (3) mit dem Phasenanschluss (17) elektrisch verbunden ist, wobei der Stromsensor (6) zwischen dem Phasenschluss (17) und dem Verbindungspunkt (18) angeordnet ist, wobei zur Übertragung von Messsignalen der Stromsensor (6) mit der Regelungsbaugruppe (7) verbunden ist.
